Europäisches Patentamt

European Patent Office

Office européen des brevets

(11) Publication number: **0 206 659 B1**

# EUROPEAN PATENT SPECIFICATION

(45) Date of publication of patent specification: **04.11.92**  (51) Int. Cl.5: **H01S  3/19**

(21) Application number: **86304510.0**

(22) Date of filing: **12.06.86**

(54) Semiconductor laser.

(30) Priority: **14.06.85 JP 128119/85**

(43) Date of publication of application:
**30.12.86 Bulletin  86/52**

(45) Publication of the grant of the patent:
**04.11.92 Bulletin  92/45**

(84) Designated Contracting States:
**DE FR GB**

(56) References cited:

**APPLIED PHYSICS LETTERS, vol. 45, no. 1, 1st July 1984, pages 98-100, American Institute of Physics, New York, US; R. LANG et al.: "Electronic state localization in semiconductor superlattices"**

**JOURNAL OF VACUUM SCIENCE & TECHNOLOGY B, vol. 3, no. 2, March-April 1985, pages 687-693, American Vacuum Society, New York, US; H. OKAMOTO: "Optical properties of superlattice and MOW laser diode"**

(73) Proprietor: **HITACHI, LTD.**
**6, Kanda Surugadai 4-chome**
**Chiyoda-ku, Tokyo 100(JP)**

(72) Inventor: **Murayama, Yoshimasa**
**4-2-1-320, Maehara-cho**
**Koganei-shi Tokyo-to(JP)**
Inventor: **Takeda, Yasutsugu**
**3-18-11, Nakaarai**
**Tokorozawa-shi Saitama-ken(JP)**
Inventor: **Nakamura, Michiharu**
**2196-283, Hirai Hinode-cho**
**Nishitama-gun Tokyo-to(JP)**
Inventor: **Shiraki, Yasuhiro**
**1-106, 3-26-1, Hirayama**
**Hino-shi Tokyo-to(JP)**
Inventor: **Katayama, Yoshifumi**
**1303-9, Shimotomi**
**Tokorozawa-shi Saitama-ken(JP)**
Inventor: **Chinone, Naoki**
**F-202, 1-47-3, Akatsuki-cho**
**Hachiouji-shi Tokyo-to(JP)**

(74) Representative: **Calderbank, Thomas Roger et al**
**MEWBURN ELLIS & CO. 2/3 Cursitor Street**
**London EC4A 1BO(GB)**

EP 0 206 659 B1

APPLIED PHYSICS LETTERS, vol. 40, no. 11, June 1982, pages 939-941, American Institute of Physics, New York, US; Y. ARAKAWA et al.: "Multidimensional quantum well laser and temperature dependence of its threshold current"

PATENT ABSTRACTS OF JAPAN, vol. 8, no. 268 (E-283)[1705], 7th December 1984; & JP-A-59 139 691 (NIPPON DENSHIN DENWA KOSHA) 10-08-1984

JAPANESE JOURNAL OF APPLIED PHYSICS. SUPPLEMENTS, supplement, 15th conference, pages 58-59, Tokyo, JP; T. FUKUZAWA et al.: "Fabrication of GaA1As multi-quantum-well buried heterostructure lasers using diffusion-induced disordering"

IEE JOURNAL OF ELECTRONIC ENGINEER-ING, vol. 21, no. 213, September 1984, page 21, Tokyo, JP; "Fujitsu refines method for semiconductor lasers"

## Description

This invention relates to a semiconductor laser, such as a Single Quantum Well (SQW) laser or a Multiple Quantum Well (MQW) laser.

It has been known since the 1960's that a semiconductor laser can be accomplished by utilizing the radiative recombination of electrons and holes at a p-n junction. However, it was only about a decade ago that CW lasing become possible in practice. The reason for this was that no one realised that it was necessary to provide a specific structure to prevent holes and electrons injected from a p-n region performing non-radiative recombination before radiative recombination. Even if the concept was known, the technique for achieving it was not developed.

About 15 years ago the "double hetero" structure was developed. This provided a potential barrier to prevent electrons injected into a p region and holes injected into an n region from moving away by a significant amount from the junction depletion layer.

The injected electrons and holes must be recombined within as short a period as possible. The most effective way to achieve this is obviously to increase the overlap of wave functions of the electrons and holes.

One of the methods is to localize spatially the electrons and holes, or the excitons formed by both of them.

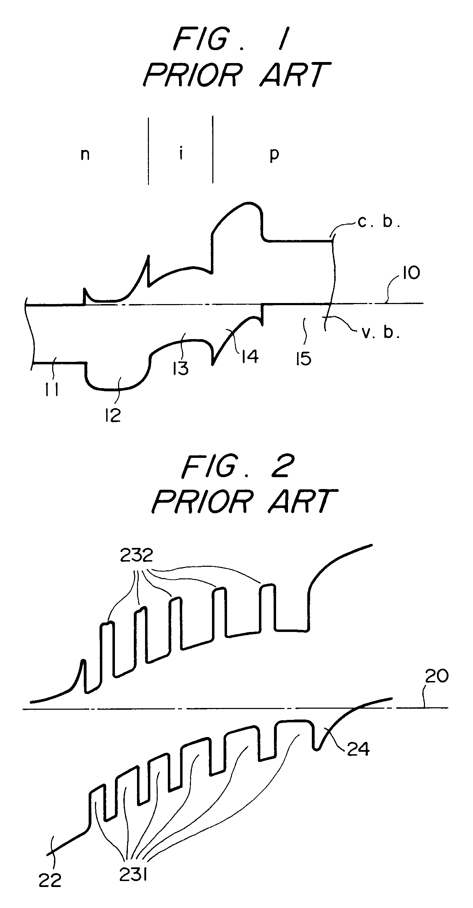

In a conventional semiconductor laser, a lightly doped layer or an undoped layer which is referred to as an "active layer" and is about 0.1 $\mu$m-thick plays a principal role in recombination. Fig. 1 of the accompanying drawings shows conceptually the energy diagram of a conventional semiconductor laser, with an active layer 13.

In Fig. 1 is shown an n-type semiconductor layer 11, a barrier layer of n-type semiconductor 12, a barrier layer of p-type semiconductor 14, and a p-type semiconductor layer 15. The active layer 13 is interposed between the barrier layers 12 and 14, which have a greater band gap than the active layer 13. Also shown is the Fermi level 10, the bottom of the conduction band c.b. and the top of the valence band v.b. Symbols n, i and p represent n-type, intrinsic and p-type semiconductors, respectively.

In contrast, in SQW or MQW semiconductor lasers, one or a large number of hetero structures of e.g. GaAs and A$\ell$GaAs, are superposed to form one or more potential well(s) and to reduce the freedom of an electron wave in a direction of current flow. It is then possible to obtain a high recombination ratio by localizing the electrons, the holes and the excitons at least in one-dimensional direction. Fig. 2 of the accompany drawings shows the energy diagram of such a laser. The portion that corresponds to the active layer 13 in Fig. 1 has an MQW structure formed by alternately superposing A$\ell$GaAs 232 and GaAs 231. It is known theoretically that in the case of an exciton equivalent to a hydrogen atom, for example, the spread of a two-dimensional exciton is $\frac{1}{2}$ that of the wave function of the three-dimensional exciton.

Also shown in Fig. 2, are the Fermi level 20, and barrier layers 22,24 of n-type and p-type, respectively.

In accordance with known semiconductor laser techniques, a high recombination ratio is obtained by forming SQW or MQW structures to reduce the threshold value and to obtain high efficiency. This is discussed in e.g. "A Prospective in Superlattice Development", Physical Society of Japan, 1984, by Leo Esaki. Nonetheless, sufficiently high efficiency cannot yet be obtained and semiconductor lasers having higher efficiency have therefore been desired.

In an article entitled "Multidimensional quantum well laser and temperature dependence of its threshold current", Applied Physics Letters, Volume 40, no. 11. June 1989, pp. 939-941 there is disclosed a semiconductor laser in which the spatial fluctuations of potential is obtained by forming isolated quantum wells in the Z-direction and the direction S perpendicular to the Z-direction, so that to obtain a periodic potential in a 3-dimensional structure in the active layer of the laser. This document thus corresponds to the pre-characterising part of claim 1.

A similar structure is also disclosed in an article entitled "Optical properties of superlattice and MQW laser diode", Journal of Vacuum Science & Technology B, Volume 3, no. 2, March-April 1985, pp. 687--693.

According to the present invention, there is provided a semiconductor laser having an active layer with potential well structure in the direction of current flow, the active layer having at least one heterojunction and being sufficiently thin to cause localization of electrons and holes or excitons formed thereby in the direction of current flow; wherein the potential well structure has a spatial fluctuation of potential for causing the localization of said electrons and holes or excitons in regions in a plane perpendicular to the direction of current flow wherein the surface of the active layer has corrugations or ruggedness of a mean pitch from 10 nm to 100 nm.

The semiconductor laser of the present invention achieves spatial fluctuation of the potential by intentionally making incomplete the periodicity of the atomic arrangement of a crystal inside the plane perpendicular to the direction of current flow. In particular, corrugations or ruggedness (hereinafter referred to generally as ruggedness) may be formed whose level difference is from 1/10 to $\frac{1}{2}$ of the mean thickness of the active layer and which has a mean pitch, between projected parts, of up to 100 nm. This ruggedness is provided on the surface of the active layer. The lower limit of the mean pitch is normally about 10 nm, imposed by restriction in the processing techniques, but a smaller pitch is possible, in principle. The theoretically preferred mean pitch of the ruggedness is about the spread of the wave function of the electron. In the case of GaAs, for example, the spread of the wave function is about 10 nm. Therefore, the mean pitch which has been believed considerably more effective than conventionally, though it may not be optimal, includes a range smaller than 100 nm.

If the mean pitch of the ruggedness exceeds 100 nm, the effect of the present invention is significantly reduced. If the difference in level of the ruggedness is smaller than the range described above, the fluctuation in potential becomes small and the effect of the present invention may become insufficient. If the level difference is greater than the range described above, on the other hand, the active layer tends to become discontinuous, which is undesirable. In addition, in the semiconductor laser of the present invention, the lasing region should be sufficiently thin to permit electrons and holes or excitons to be localized in the direction of current flow and the laser has at least one hetero junction, as in the prior art.

Embodiments of the invention will now be described in detail, by way of example, with reference to the accompanying drawings, in which:

Fig. 1 is an energy diagram of a semiconductor laser having a conventional double hetero structure, and has already been discussed;

Fig. 2 is an energy diagram showing the structure of the active region of a conventional MQW semiconductor laser, and has already been discussed;

Fig. 3 is a sectional view of a semiconductor laser in accordance with one embodiment of the present invention;

Fig. 4 is a partial sectional view of a part of the semiconductor laser shown in Fig. 3 near the active layer;

Fig. 5 is a plan view for explaining the active region of the semiconductor laser shown in Fig. 3; and

Fig. 6 is a plan view for explaining the active region of a semiconductor laser in accordance with another embodiment of the present invention.

First the phenomenon referred to as "Anderson localization" being the basis of the technical concept of the present invention, will be described.

The most fundamental concept in solid state physics is that an electron wave forms an "energy band" that spreads throughout a crystal due to the complete periodicity of the atomic arrangement in an ideally perfect crystal. Its band width will be called "B".

In practical crystals, on the other hand, the energy band generally fluctuates spatially due to imperfectnesses that develop in the crystal. Suppose the energy band of a given part of the crystal is different from that of other parts (from the aspect of energy) the order of the potential fluctuation is "W". Consider the case where W is sufficiently great and substantially satisfies the relation $W \geq B$. Since the energy bands deviate from each other to an extent such that they do not overlap, it is self-explanatory that the electrons existing in one part cannot spread to other parts. Localizing the electron resulting from the spatial fluctuation of the potential of the electron is called "Anderson localization" as it is named after Anderson, the researcher who proposed such a concept for the first time. It is also known that the conditions discussed above are more severe than occur practically. In practical semiconductors, only a limited state at the bottom of the band is occupied by electrons. Under the condition of about $W \geq B/100$, for example, the states near the bottom of the band are localized.

Even after localization in one-dimension due to the potential well in the direction of current flow, the electrons, the holes and the excitons are not generally localized in the remaining dimensions. In such a system, the electrons, the holes and the excitons spread sufficiently inside the plane perpendicular to the current flowing direction and form a state which is referred to as "two-dimensional electron gas (2DEG)".

The present invention proposes limiting the freedom of the electrons in this plane in order to localize them. Holes and excitons are also localized in this plane. By so doing, the present invention reduces the spread of the wave functions of the electrons and the holes to increase their overlap, or limits the two-dimensional freedom of, and localizes, the excitons which are formed by the electrons and the holes and are equivalent to hydrogen atoms to obtain smaller excitons, and reduces the life of these excitons in order to improve the efficiency of luminescence.

The above explanation discusses the effect of localization inside the two-dimensional plane as the active region of the semiconductor laser, but the following effects can also be expected. Ordinarily, a semiconductor laser is scribed into devices at the final stage of its production process. At this time, passivation must be applied to the scribed surface by suitable means. Such passivation helps to prevent degradation after the passage of a long period of time and also improves the efficiency. This is because the scribed surface ordinarily functions as a non-radiative recombination centre. It is therefore preferred that the injected electrons and holes avoid the scribed surface. It can easily be seen that in order to accomplish this, the electrons and the holes should be localized inwardly in the device.

It is possible to employ the following methods to form the spatial fluctuation of the potential:

a) predetermined patterning is first made by using any one of the photolithography processes using chemical etching, ion-beam etching or plasma etching, the direct ion-beam etching method and the selective growth method by photo-CVD (photo-chemical vapor deposition method);

b) growth involving ruggedness of at least two atomic layers on an average may be effected by a Molecular Beam Epitaxy (MBE) method.

Specific methods of forming the ruggedness will be described in further detail in the following embodiments.

Although the embodiments of the present invention illustrate examples of a GaAs-AℓGaAs system laser and an InP-InGaAsP system laser, the present invention can of course be applied to semiconductor lasers using other semiconductor materials.

Embodiment 1

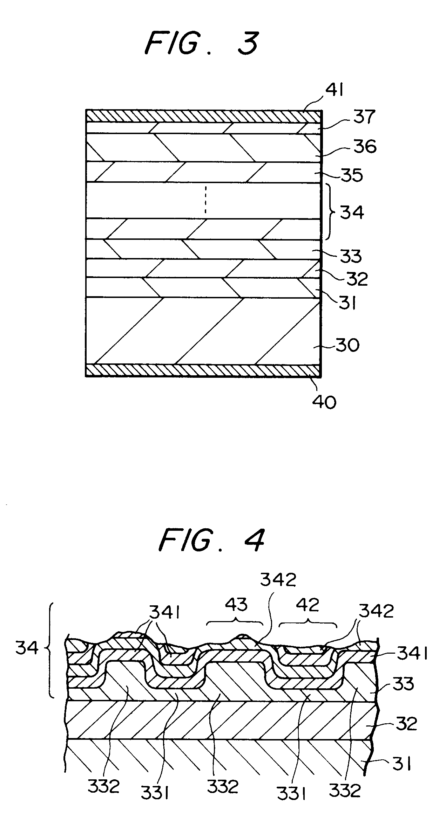

Fig. 3 is a sectional view showing the semiconductor laser in accordance with a first embodiment and Fig. 4 is a partial sectional view showing in detail the parts of the laser near its active layer.

A p-type $Aℓ_{0.45}Ga_{0.55}As$ layer 31 to which Be is doped to a high concentration of at least $1 \times 10^{17}$ $cm^{-3}$ is grown by use of a molecular beam epitaxy apparatus to a thickness of 10 nm on p-type GaAs substrate 30 to which Zn is doped in about the same concentration. Next, a GaAs layer 32, with no intentional doping, is grown in a thickness of 10 nm within about 10 minutes as an active layer, but at the final stage of this growth, the temperature of a Knudsen cell (K-cell) for evaporating As is set to a temperature which is about 10°C lower than the optimal temperature for the growth on a mirror surface for one minute. Generally, the total thickness of the active layer is from 60 to 100 nm. Next, the temperature of the K-cell for As is reduced, and an undoped AℓGaAs layer 33 is grown in an As-deficient atmosphere, whereby the AℓGaAs layer 33 grows in the island-like form shown in Fig. 4. After the temperature is returned again to the optimal temperature, ten layers of GaAs and $Aℓ_{0.2}Ga_{0.8}As$ each of which is 3 nm-thick are grown alternately without intentional doping (these regions are represented by 34 in Figs. 3 and 4 as the GaAs layer 341 and the AℓGaAs layer 342 that together form the region 34).

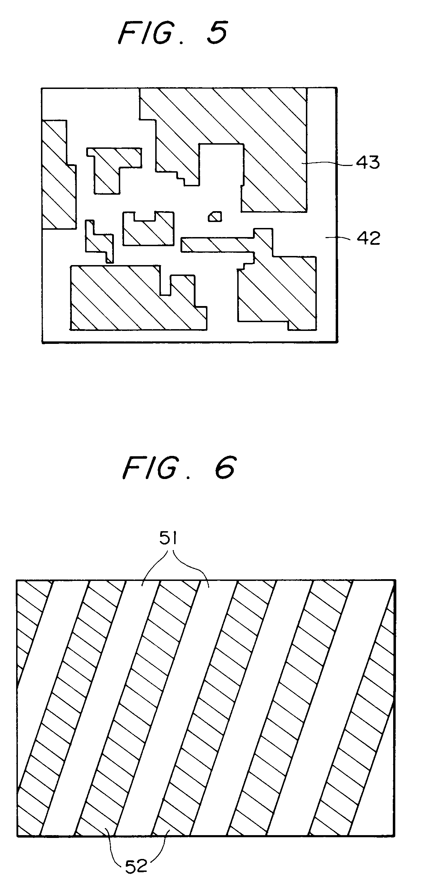

Fig. 5 schematically illustrates the very small planar structure of the active layer formed in the manner described above. In this case, it is customary to call the GaAs layer the "well layer" and the AℓGaAs layer, the "barrier layer". The AℓGaAs 332 is 10nm-thick at the island-like part 43 which is grown in the projected form, and the AℓGaAs 331 at the other parts 42 is about 3 nm-thick. The island-like growth does not continue in the second and subsequent layers because the growth is effected at the optimal temperature. However, the ruggedness in the first layer causes ruggedness in the second layer and so on, but the ruggedness gradually reduces and the layers become flat. The projected parts 43 form the thin active layer as a whole while the recessed portions 42 form the thick active layer as a whole. Therefore, the difference of their thickness is about 7 nm, and since the projected part has a higher energy than the recessed portion, the electrons, the holes and the excitons are localized in the recessed part.

Thereafter, an $n-Aℓ_{0.45}Ga_{0.55}As$ layer 35 about 1 μm-thick whose band gap is greater than that of the barrier layer described above and which has a conductivity type opposite to that of the substrate and a $n-Ga_{1-w}Aℓ_wAs$ (w = 0.45 ~ 0.6) layer 36 are grown as a cap layer about 0.3 μm-thick on the multi-layered region 34 formed by alternately laminating AℓGaAs and GaAs, in the same way as the conventional GaAs type semiconductor lasers. Generally, after an n-GaAs layer 37 is formed to a thickness of 0.1 μm on the cap layer, an n-electrode (Au-Ge-Ni-Au) 41 and a p-electrode (Cr-Au) 40 are formed on the surface of the n-type GaAs 37 and the lower surface of the p-type GaAs substrate 30, respectively. Finally, a semiconductor laser having a resonator length of 300 μm is produced by known cleavage processes.

The semiconductor laser thus produced has an efficiency improved by about 20% over conventional semiconductor lasers.

Embodiment 2

A 5 μm-thick buffer layer consisting of p-type InP is formed by known epitaxy on a p-type InP substrate, and then a semiconductor laser having an active region consisting of a SQW of InGaAsP-InAsP is produced by Organometallic Vapor Phase Epitaxy (OMVPE) using trimethyl-indium (TMI), trimethyl-gallium (TMG), $PH_3$ and $AsH_3$ as the sources. In this case, two InGaAsP layers which are about 100 nm-thick serve as the barrier layer, and an InAsP layer, forming a well layer, is interposed between these layers. When a 10 nm-thick layer of InAsP is grown, the interference pattern of an Ar laser is radiated onto the surface of the substrate from outside of the reactor and the thickness changes in a fringe-like form.

A Mach-Zehnder interferometer is used for forming the interference pattern. The pitch of the fringe is 100 nm and the difference in level of the ruggedness is 2 to 3 nm. When two argon lasers radiate such that their interference fringes cross at right angles to each other, the thickness changes in a checkered pattern. The formation of the fringe-like ruggedness is an application of the opto-CVD method. The change of thickness of the active layer inside the plane also causes fluctuation of the potential and hence localization of the electrons, the holes and the excitions inside the plane. Fig. 6 is a plan view schematically illustrating the active layer in this embodiment. In that figure is shown a region 51 in which fringe-like growth occurs excessively, and a region 52 in which fringe-like growth is not sufficient.

The change of thickness can also be obtained by photo etching after growth. However, since ion beam etching will introduce defects into the active layer, which is the most important part of the laser, careful attention must be paid to subsequent annealing. From this aspect, chemical etching is more advantageous. Hardly any improvement can be observed in the efficiency of luminescence by ion beam etching, and this is believed to result from the technical limit of the current photolithography techniques using ion beams. When work is conducted to obtain the fringe-like form, the effect of localization is not very great if its width is as large as about 0.1 $\mu$m. Since the wave function of the electron is about 10 nm in the case of GaAs, the change of potential must be kept at substantially the same level.

Though the above illustrates the examples of photo etching methods, it is also possible to effect etching without using the photo resist by directly scanning the substrate surface while controlling the ion beam electrically. In such a case, a random pattern is preferable, in which the electron can be localized most easily.

The semiconductor laser of this embodiment may have substantially the same structure as an ordinary InP-InGaAsP system semiconductor lasers except that SQW of InGaAsP-InAsP is used for the active region, and in addition, ruggedness is formed in order to cause the fluctuation of potential on the plane of the thickness of the active layer.

In accordance with the method described above, an improvement of about 10% can be observed in the current threshold value which is one of the evaluation factors of semiconductor lasers.

As described in the foregoing, the present invention can provide the improvement of 10 to 30% in the efficiency of luminescence and the current threshold value when compared with those conventional semiconductor lasers.

## Claims

1. A semiconductor laser having an active layer (32,33,34) with potential well structure in the direction of current flow, the active layer having at least one heterojunction and being sufficiently thin to cause localization of electrons and holes or excitons formed thereby in the direction of current flow; wherein the potential well structure has a spatial fluctuation of potential for causing the localization of said electrons and holes or excitons in regions in a plane perpendicular to the direction of current flow;

   characterised in that:

   the surface of the active layer has corrugations or ruggedness (43,51) of a mean pitch from 10 nm to 100 nm.

2. A semiconductor laser according to claim 1 wherein the potential well structure is a quantum well structure in the direction of current flow.

3. A semiconductor laser according to claim 2 wherein the quantum well structure is a single quantum well

4. A semiconductor laser according to claim 2 wherein the quantum well structure is multiple quantum wells.

5. A semiconductor laser according to any one of claims 1 to 4 wherein said corrugations or ruggedness have a level difference of from 1/10 to $\frac{1}{2}$ of the mean thickness of the active layer.

## Patentansprüche

1. Halbleiterlaser mit einer aktiven Schicht (32, 33, 34) mit Potentialtopfstruktur in der Richtung des Stromflusses, wobei die aktive Schicht wenigstens einen Heteroübergang aufweist und genügend dünn ist, um eine Lokalisierung der Elektronen und Löcher oder der Excitonen zu verursachen, die dadurch in der Richtung des Stromflusses gebildet werden; und wobei die Potentialtopfstruktur eine räumliche Änderung des Potentials aufweist, um die Lokalisierung der Elektronen und Löcher oder der Excitonen in Bereichen in einer Ebene senkrecht zur Richtung des Stromflusses zu veranlassen;

   dadurch gekennzeichnet, daß

   die Oberfläche der aktiven Schicht Rillen oder Unebenheiten (43, 51) mit einem mittleren Abstand von 10 nm bis 100 nm aufweist.

2. Halbleiterlaser nach Anspruch 1, wobei die Potentialtopfstruktur eine Quanten-Potentialtopfstruktur in der Richtung des Stromflusses ist.

3. Halbleiterlaser nach Anspruch 2, wobei die Quanten-Potentialtopfstruktur ein einfacher Quanten-Potentialtopf ist.

4. Halbleiterlaser nach Anspruch 2, wobei die Quanten-Potentialtopfstruktur ein mehrfacher Quanten-Potentialtopf ist.

5. Halbleiterlaser nach einem der Ansprüche 1 bis 4, wobei die Rillen oder Unebenheiten einen Höhenunterschied von 1/10 bis 1/2 der mittleren Dicke der aktiven Schicht haben.

**Revendications**

1. Laser à semiconducteurs possédant une couche active (32,33,34) possédant une structure de puits de potentiel dans la direction du flux de courant, la couche active possédant au moins une hétérojonction et étant suffisamment mince pour réaliser une localisation d'électrons et de trous ou d'excitons formés de ce fait dans la direction du flux de courant; dans lequel la structure de puits de potentiel présente une variation spatiale de potentiel provoquant la localisation desdits électrons et trous ou excitons dans des régions d'un plan perpendiculaire à la direction du flux de courant;
caractérisé en ce que :
la surface de la couche active possède des ondulations ou une rugosité (43,51) possédant un pas moyen de 10 nm à 100 nm.

2. Laser à semiconducteurs selon la revendication 1, dans lequel la structure de puits de potentiel est une structure de puits de quanta dans la direction du flux de courant.

3. Laser à semiconducteurs selon la revendication 2, dans lequel la structure de puits de quanta est formée par un seul puits de quanta.

4. Laser à semiconducteurs selon la revendication 2, dans lequel la structure de puits de quanta est formée de multiples puits de quanta.

5. Laser à semiconducteurs selon l'une quelconque des revendications 1 à 4, dans lequel lesdites ondulations ou ladite rugosité possè

dent une différence de niveau comprise entre 1/10 et 1/2 de l'épaisseur moyenne de la couche active.

## FIG . 1
## PRIOR ART

## FIG . 2
## PRIOR ART

## FIG. 3

## FIG. 4

## FIG. 5

## FIG. 6